# EUROPEAN PATENT APPLICATION

(11) **EP 4 503 003 A1**
(43) Date of publication of application: **05.02.2025**
(21) Application number: 22934917.0
(22) Date of filing: 14.12.2022
(51) Int. Cl.: G09G 3/32, H01L 25/075, H01L 33/48, H05B 45/00, F21V 23/00

(54) **LED CARRIER PLATE AND DISPLAY DEVICE THEREOF**

(30) Priority: 27.03.2022 CN 202210309309
(71) Applicant: MXW Device (Shenzhen) Co., Ltd., Shenzhen, Guangdong 518000 (CN)
(72) Inventor: YUAN, Chuzhuo, Shenzhen, Guangdong 518000 (CN); CHEN, Du, Shenzhen, Guangdong 518000 (CN); LU, Donghua, Shenzhen, Guangdong 518000 (CN)
(74) Representative: Cabinet Chaillot
(86) International application number: PCT/CN2022/138997
(87) International publication number: WO 2023/185101

(57) **Abstract**

An LED carrier plate, comprising a carrier plate front side and a carrier plate back side, wherein a plurality of through holes penetrate the carrier plate front side and the carrier plate back side, and the plurality of through holes at least comprise two rows of through holes; at least every three through holes enclose one island-shaped carrier plate region on the carrier plate front side; and at least two electrode pins are arranged in the island-shaped carrier plate region, and are configured to be connected to an LED arranged on the carrier plate front side. In addition, further disclosed is an LED display device using the LED carrier plate. The carrier plate and the LED display device can achieve both light transmission and LED display/lighting effects.

## Description

### TECHNICAL FIELD

The present invention relates to the field of LED, and specifically to an LED carrier plate and a display device thereof.

### BACKGROUND ART

Currently, a wide range of types of LED carrier plates exist in prior art. When they are used for lighting or display, the market side begins to put forward demands of transparent or semi-transparent lighting or display.

For example, when they are used for display, the semi-transparent display puts forward new requirements for the LED carrier plate structure. Overall, it is urgent to develop the LED carrier plate technology and display device thereof that take into account light transmission and display visual effects in this field.

### SUMMARY

### Technical Problem

The present invention solves the technical problems of transparent or semi-transparent displays of LED.

### Solution of Technical Problem

### Technical Solution

The present invention provides an LED carrier plate, including:
a carrier plate front side and a carrier plate back side, wherein a plurality of through holes pass through the carrier plate front side and the carrier plate back side, and
the plurality of through holes includes at least 2 rows of through holes, wherein
at least every 3 through holes enclose one island-shaped carrier plate region on the carrier plate front side, wherein
the island-shaped carrier plate region is provided with at least 2 electrode pins, and the electrode pins are configured to connect LED illuminants arranged on the carrier plate front side.

Preferably,
the carrier plate back side does not provided with any IC and/or component configured to connect the LED illuminants; and
the LED illuminants are located on the island-shaped carrier plate region and do not shield any through hole.

Preferably,
for each row of through holes on the carrier plate, adjacent through holes are arranged with equal space in the row, and/or, for each row of LED illuminants on the carrier plate, adjacent LED illuminants are arranged with equal space within the row.

Preferably,
the carrier plate does not provided with grilles in rows or columns.

Preferably,
at least every 4 through holes enclose one island-shaped carrier plate region.

Preferably,
the carrier plate is rectangular or other polygonal, circular, or other shapes.

Preferably,
when at least every 4 through holes enclose one island-shaped carrier plate region, wherein
geometric center lines of the 4 through holes constitute one rectangle, and one edge of the rectangle is parallel or perpendicular to one edge of the carrier plate.

Preferably,
when at least every 4 through holes enclose one island-shaped carrier plate region,
the geometric center lines of the 4 through holes constitute one rectangle, and at least one edge of the rectangle is not parallel to any edge of the carrier plate.

Preferably,
the electrode pins include: a first pin and a second pin, wherein the first pin and second pin have following features:
(1) the first pin is configured to electrically connect a positive electrode of an LED chip in the LED illuminants, and
   the second pin is configured to electrically connect a negative electrode of the LED chip in the LED illuminants; and
(2) the first pin is configured to electrically connect a first input pin of a driver IC of the LED chip in the LED illuminants, and
   the second pin is configured to electrically connect a second input pin of the driver IC of the LED chip in the LED illuminants.

Preferably,
the electrode pins include: the first pin, the second pin, and a third pin, wherein the first pin, second pin, and third pin have the following features:
the first pin is configured to electrically connect a power supply positive electrode/VCC end of the LED illuminants;
the second pin is configured to electrically connect a power supply negative electrode/GND end of the LED illuminants; and
the third pin is configured to electrically connect a data signal input pin DIN end of the LED illuminants.

Preferably,
data input signal wires of the LED illuminants are arranged on the carrier plate front side between 1st-row through holes and 2nd-row through holes and along a first direction on the carrier plate.

Preferably,
the carrier plate further includes 3rd-row through holes, wherein
ground wires of the LED illuminants are arranged on the carrier plate back side between the 1st-row through holes and the 2nd-row through holes and between the 2nd-row through holes and the 3rd-row through holes, and along the first direction on the carrier plate, wherein
a first carrier plate back side region between the 1st-row through holes and the 2nd-row through holes and a second carrier plate back side region between the 2nd-row through holes and the 3rd-row through holes are grounded.

Additionally, the present invention discloses an LED display device adopting the LED carrier plate described above.

### Benefit Effect of the present Invention

### Benefit Effect

The above carrier plate of the present invention can take into account light transmission and LED display/lighting effects, and can even realize an equally spaced display effect. Furthermore, it even realizes a visual effect equally spaced and improving light transmittance.

### BRIEF DESCRIPTION OF DRAWINGS

### DESCRIPTION OF DRAWINGS

In order to more clearly illustrate the technical solutions in the embodiments of the present invention, the following will briefly introduce the drawings to be used in the embodiments. It is to be understood that the following drawings illustrate only certain embodiments of the present invention, and therefore should not be regarded as a limitation of the scope. For persons of ordinary skill in the field, other relevant drawings can be obtained based on these drawings without inventive efforts.
FIG. 1 shows a schematic structure diagram of a front side of an LED carrier plate provided by an embodiment of the present invention.
FIG. 2 shows a schematic structure diagram of a back side of an LED carrier plate provided by an embodiment of the present invention.
FIG. 3 shows a schematic structure diagram of a front side of an LED carrier plate provided by another embodiment of the present invention.
FIG. 4 shows a schematic structure diagram of a front side of an LED carrier plate provided by another embodiment of the present invention.

### PREFERRED EMBODIMENT OF THE PRESENT INVENTION

### DETAILED DESCRIPTION OF EMBODIMENTS

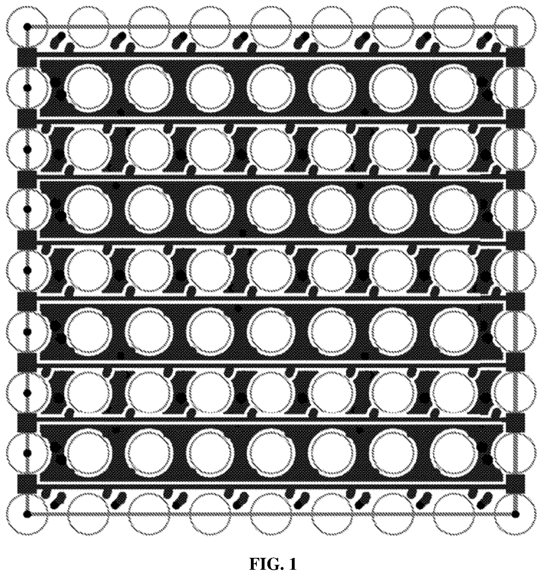

In order to make the purpose, technical solutions, and advantages of the embodiments of the present invention clearer, the technical solutions in the embodiments of the present invention will be described clearly and completely below in conjunction with the drawings FIG. 1 to FIG. 4 in the embodiments of the present invention. It is clear that the embodiments described are partial embodiments of the present invention, but not all of the embodiments. The components in the embodiments of the present invention generally described and shown in the drawings herein may be arranged and designed in multiple different configurations.

In one embodiment, the present invention discloses an LED carrier plate, including:
a carrier plate front side and a carrier plate back side, wherein a plurality of through holes pass through the carrier plate front side and the carrier plate back side, and
the plurality of through holes includes at least 2 rows of through holes, wherein
at least every 3 through holes enclose one island-shaped carrier plate region on the carrier plate front side, wherein
the island-shaped carrier plate region is provided with at least 2 electrode pins, and the electrode pins are configured to connect LED illuminants arranged on the carrier plate front side.

For the above embodiment, the plurality of through holes of the island-shaped carrier plate region play roles of light transmission and even ventilation, and the LED illuminants play roles of display/lighting. A conventional situation for each island-shaped carrier plate region is that the corresponding LED illuminants are arranged on the island-shaped carrier plate region, and all through holes jointly take on roles of light transmission or even ventilation. However, the present invention does not exclude the following atypical solution: one LED illuminant is arranged above one or more through holes; spans 2 different island-shaped carrier plate regions on two sides (or surrounding) of the one or more through holes; and still connects 2 electrode pins of these island-shaped carrier plate regions. For this reason, it is limited in the above embodiment that the electrode pins are configured to connect the LED illuminants arranged on the carrier plate front side, and are not limited to that the electrode pins are configured to connect the LED illuminants arranged on the island-shaped carrier plate region.

When the plurality of through holes are distributed in a certain regulation, the LED illuminant will present an excellent display effect with a uniform vision. The intuitive feeling of human eyes will be improved because of the regular distribution of through holes, which is more beneficial to improve the visual effect especially when viewing a distance.

Exemplarily, FIG. 1 to FIG. 2 show the case that the through holes are circular. It can be understood that the through holes can be of other uniform or non-uniform shapes, and the shapes more depend on the requirement of the visual effect. The circle or other symmetrical shapes are preferable embodiments of the shapes of the through holes, especially the circle. Preferably, each circular through hole is the circle with the same diameter, but the present invention is not limited to the circular through holes with the uniform shape and size.

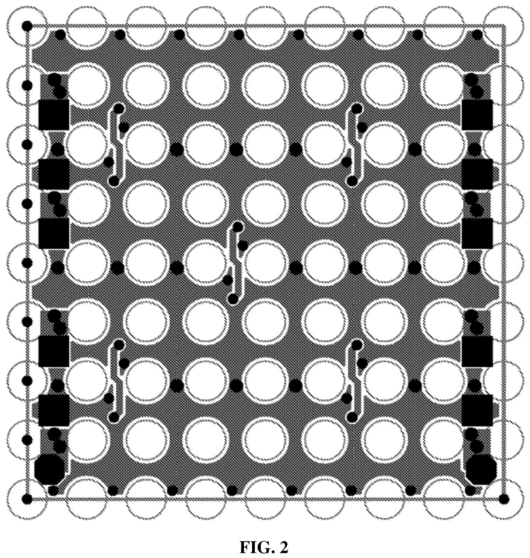

It is to be understood, as for the embodiments shown in FIG. 1 and FIG. 2, the island-shaped carrier plate region of the LED carrier plate is exactly a part of the carrier plate region that is not penetrated besides the through holes. From the overall perspective of the LED carrier plate, the rest of the carrier plate region is equivalent to an island group besides all through holes. For the island group, wherein at least every 3 through holes enclose one island-shaped carrier plate region on the carrier plate front side, the whole island group is consisted of n connected island-shaped carrier plate regions.

As shown in FIG. 1 and FIG. 2, when the diameter of the circular through hole is larger than the size of the island-shaped carrier plate region and the through hole is configured for the light transmission, it will result in that the carrier plate has a higher light transmittance; and when the LED does not work, natural lights can pass through the plurality of through holes, so that the carrier in this solution has certain light transmittance.

In one embodiment, the LED illuminant includes a patch-type LED.

In another embodiment,
the carrier plate back side does not provided with any IC and/or component configured to connect the LED illuminant.

The embodiment embodies the other major innovation of the present invention compared with the prior art. When the LED illuminant itself further includes a driver IC (which does not limit to current-limiting IC or constant-current IC) besides the LED chip, the carrier plate only needs to supply power to the LED illuminant by the corresponding electrodes on the carrier plate front side, and the carrier plate back side does not need to be provided with any IC and/or component connecting the LED illuminant.

In another embodiment, at least every 4 through holes enclose one island-shaped carrier plate region.

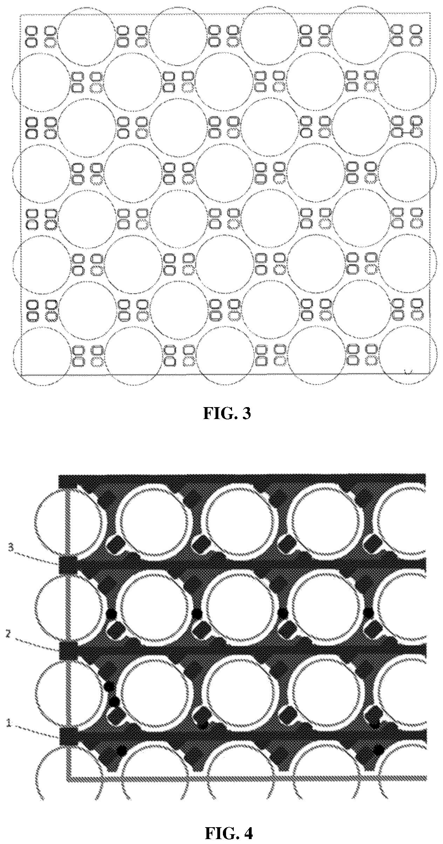

For example, FIG. 1 and FIG. 3 both show that 4 through holes enclose one island-shaped carrier plate region. However, it must be noted, since 3 through holes can enclose a relatively enclosed region, the present invention is not limited to 4 through holes.

In another embodiment, for each row of through holes on the carrier plate, adjacent through holes are arranged with equal space in the row.

In another embodiment, for each row of LED illuminants on the carrier plate, adjacent LED illuminants are arranged with equal space in the row.

It can be understood that both of the foregoing embodiments are beneficial to realize the visual effect of equal space.

In another embodiment, the carrier plate does not provided with grilles in rows or columns.

For the embodiment, compared with the conventional LED carrier plate or LED transparent display device (e.g., an LED transparent display screen) with one or more horizontal or vertical grilles,

the present invention can omit the grilles in rows or columns, wherein the reason is that the present invention can meet basic requirements of mechanical properties of the carrier plate by the island group formed by the plurality of island-shaped carrier plate regions without the mandatory arrangement of one or more grilles in the rows or columns. In other words, the embodiment has a mechanically enhanced structure. Additionally, the grille itself affects the visual effect, which is because that the grille is easy to cause a visual illusion, which is also a consideration factor to omit the grilles in the embodiment.

In another embodiment, the carrier plate is rectangular or other polygonal, or circular, or other shapes.

Taking FIG. 1 and FIG. 2 as an example, it can be found that the carrier plate is rectangular, which is corresponding to the general condition of the LED lighting or display. It should be noted that the rectangles include the common rectangle and square. However, if it needs to provide a special decorative effect or special visual effect, such as a tree shape, etc., the carrier plate of the present invention obviously does not exclude other polygons besides the rectangle. It can be the circle, or other shapes, even other carrier plates with irregular shapes can also be provided.

In another embodiment, when the at least every 4 through holes enclose one island-shaped carrier plate region, wherein

the geometric center lines of the 4 through holes constitute one rectangle, and one edge of the rectangle is parallel or perpendicular to one edge of the carrier plate.

For the embodiment, the carrier plates shown in FIG. 1 and FIG. 2 belong to this case. It can be understood that this design appears to be more regular, since a line where the geometric center line of the through hole is located is parallel or perpendicular to one edge of the carrier plate. Especially when the carrier plate is rectangular, each edge of the rectangle formed by the geometric center lines of the 4 through holes will be parallel to one of the edges of the carrier plate.

In another embodiment, when the at least every 4 through holes enclose one island-shaped carrier plate region, wherein the geometric center lines of the 4 through holes constitute one rectangle, and at least one edge of the rectangle is not parallel to any edge of the carrier plate.

It is to be noted that the embodiment and the previous embodiment relate to the arrangement of the through holes. Comparatively, the arrangement of the through holes in the previous embodiment is relatively conventional, wherein the geometric center line of the corresponding through holes is parallel or perpendicular to one edge of the carrier plate, and the arrangement of the through holes in the embodiment is more flexible compared with the previous embodiment.

Particularly, comparing FIG. 3 with FIG. 1, when the carrier plates with the same size and the through holes with the same diameter are provided, and the arrangement of the through holes in FIG.3 is equivalent to the arrangement of the diagonal through holes, wherein each row of diagonal through holes is parallel to each other. The light transmittance is easy to calculate in cases of FIG. 1 and FIG. 3. It is to be noted that the light transmittance of FIG. 3 can be further improved, and the number and the energy consumption of LED illuminants can be significantly reduced. It is measured that about half of LED illuminants are reduced in FIG. 3 compared to FIG. 1, which is very meaningful. As in the scene of LED lighting or display, people are often far away from the LED device. At this time, distant viewing does not result in a significant regression of the visual effect under the premise of significantly reducing the number of LED illuminants, especially for the LED lighting or display of large size, which can still meet the requirements of the visual effect.

In another embodiment, the electrode pins include: a first pin and a second pin, wherein the first pin and second pin have following features:
(1) the first pin is configured to electrically connect a positive electrode of the LED chip in the LED illuminants, and
   the second pin is configured to electrically connect a negative electrode of the LED chip in the LED illuminants; and
(2) the first pin is configured to electrically connect a first input pin of a driver IC of the LED chip in the LED illuminants, and
   the second pin is configured to electrically connect a second input pin of the driver IC of the LED chip in the LED illuminants.

It is to be understood that the embodiment indicates that the LED carrier plate of the present invention is not necessarily limited to three types of pins or more. Obviously, when the LED lights, a minimum requirement for the LED itself is a two-wire power supply whether driven by AC or DC. Due to the development of LED chip technology, even if no driver IC is provided, the LED illuminant can also be formed by utilizing a certain number of LED chips occupying smaller areas, and is directly driven by AC or DC. Therefore, the above embodiments are the specific arrangement of the first pin and second pin when the driver IC is provided or not.

In another embodiment, the electrode pins include: the first pin, the second pin, and a third pin, wherein the first pin, second pin, and third pin have the following features:
the first pin is configured to electrically connect a power supply positive electrode/VCC end of the LED illuminants;
the second pin is configured to electrically connect a power supply negative electrode/GND end of the LED illuminants; and
the third pin is configured to electrically connect a data signal input pin DIN end of the LED illuminants.

In terms of the embodiment, it particularly aims to LED products involving the data signal input, so that it selects the conventional method of three wires and three pins.

However, in conjunction with the embodiment and the previous embodiment, it is to be particularly noted that in the field of LED drivers, a technology has appeared that transmitting the data signal when supplying power by utilizing power supply lines such as zero and fire wires/positive and negative wires, and it is equivalent to carrier technology.

This means that even for the previous embodiment, it can still transmit the data signal even if there are only the first and second pins.

Regardless of whether the data signal is for different LED illuminants, or a specific coded signal of different LED chips in a single LED illuminant; or
regardless of whether the data signal is an address code signal of the specific LED illuminant/LED chip, or a color signal of the lighting or display color,
the corresponding data signals can all be transmitted by utilizing the carrier technology.

In another embodiment, the electrode pins further include a fourth pin, wherein the fourth pin is configured to electrically connect a data signal output pin DOUT end of the LED illuminant.

In another embodiment, the data input signal wires of the LED illuminants are arranged on the carrier plate front side between the 1st-row through holes and the 2nd-row through holes and along the first direction on the carrier plate.

Referring to FIG. 4, a plurality of data input signal wires are shown in FIG. 4 at left side: 1DI (the reference number 1 in FIG. 4), 2DI (the reference number 2 in FIG. 4), 3DI (the reference number 3 in FIG. 4), etc.

In another embodiment, the carrier plate further includes the 3rd-row through holes, wherein
the ground wires of the LED illuminants are arranged on the carrier plate back side between the 1st-row through holes and the 2nd-row through holes and between the 2nd-row through holes and the 3rd-row through holes, and along the first direction on the carrier plate, wherein
the first carrier plate back side region between the 1st-row through holes and the 2nd-row through holes and the second carrier plate back side region between the 2nd-row through holes and the 3rd-row through holes are grounded.

For the embodiment, as shown in FIG. 2, it is to ensure that all ground wires are grounded, so as to prevent the electrical potential difference due to not being grounded.

In another embodiment, the carrier plate further includes a plurality of through holes of a first type, wherein the carrier plate is configured to electrically connect to the power supply negative electrode/GND end of the LED illuminant by the through holes of the first type.

In another embodiment, the carrier plate further includes a plurality of through holes of a second type, wherein the carrier plate is configured to electrically connect to the power supply positive electrode/VCC end of the LED illuminant by the through holes of the second type.

Referring to FIG. 2, in another embodiment,
the extension direction of the 1st-row through holes and the 2nd-row through holes is defined as a first direction parallel to an edge (such as the upper edge) of the carrier plate, and the 3rd-row through holes is similarly along the first direction. In this case,
along a second direction approximately perpendicular to the first direction, the carrier plate back side is provided with conductive wires for connecting the through holes of two types.

Furthermore, referring to FIG. 4, in another embodiment,
on the carrier plate front side, the island-shaped carrier plate region is provided with two through holes of the second type, and two through holes of the second type are connected by the conductive wire.

In another embodiment, two ends of the carrier plate front side are provided with:
a first type connection terminal for electrically connecting to the power supply positive electrode/VCC end of the LED illuminant; and
two ends of the carrier plate back side is provided with:
a second type connection terminal for electrically connecting to the power supply negative electrode/GND end of the LED illuminant.

Therefore, at two ends of the carrier plate, the carrier plate can be connected with other carrier plates with the same structure in front and back, which only needs to connect the first type and second type connection terminals of the front and back carrier plates to each other. It is to be understood that the first type and second type connection terminals can be evenly distributed at two ends of the carrier plate front side, and the number can be multiple.

In another embodiment, two ends of the carrier plate front side are further provided with:
the data signal input pin DIN end for electrically connecting the LED illuminants.

In this way, even if the data signal input is involved, the carrier plate can also be connected with other carrier plates with the same structure in front or back.

In another embodiment, the LED carrier plate is selected from a material capable of free bending or deforming.

It can be understood that it is beneficial to realize the visual effect with a larger freedom degree.

In another embodiment, the LED carrier plate is selected from a transparent material.

Additionally, the present invention further discloses an LED display device, which adopts the LED carrier plate described in any of the foregoing embodiments.

In another embodiment, the LED display device further includes the LED illuminants.

In another embodiment, the LED display device does not provided with a support structure.

For the embodiment, typically, compared with the conventional display device (such as a grille screen) with the grilles, the mechanical strength of the device itself is insufficient, so that it needs additional support structures, including, but not limited to the grille, and additional structural frames besides the grille, etc.

In another embodiment, since the LED carrier plate back side can omit any IC and/or component, the LED display device can be mounted on any surface or between any interlayers.

The foregoing is only specific embodiments of the present invention, but the scope of protection of the present invention is not limited thereto. Any change or replacement that can easily be thought of by a person familiar with the technical field within the technical scope disclosed by the present invention, shall be covered by the protection scope of the present invention. Therefore, the scope of protection of the present invention shall be governed by the scope of protection of the claims.

## Claims

1. An LED carrier plate, **characterized by** comprising:
a carrier plate front side and a carrier plate back side, wherein a plurality of through holes pass through the carrier plate front side and the carrier plate back side, and
the plurality of through holes comprises at least 2 rows of the through holes, wherein
at least every 3 of the through holes enclose one island-shaped carrier plate region on the carrier plate front side, wherein
the island-shaped carrier plate region is provided with at least 2 electrode pins, and the electrode pins are configured to connect LED illuminants arranged on the carrier plate front side.

2. The LED carrier plate according to claim 1, wherein the carrier plate back side does not provided with:
any IC and/or component configured to connect the LED illuminants; and
the LED illuminants are located at the island-shaped carrier plate region and do not block any through hole.

3. The LED carrier plate according to claim 1, wherein
for each row of the through holes on the carrier plate, adjacent through holes are arranged with equal space in the row; and/or,
for each row of the LED illuminants on the carrier plate, adjacent LED illuminants are arranged with equal space in the row.

4. The LED carrier plate according to claim 1, wherein
the carrier plate does not provided with grilles in rows or columns.

5. The LED carrier plate according to claim 1, wherein
at least every 4 of the through holes enclose one island-shaped carrier plate region.

6. The LED carrier plate according to claim 1, wherein
the carrier plate is polygonal or circular.

7. The LED carrier plate according to claim 1, wherein
when at least every 4 of the through holes enclose one island-shaped carrier plate region,
geometric center lines of the 4 through holes constitute one rectangle, and one edge of the rectangle is parallel or perpendicular to one edge of the carrier plate; or
geometric center lines of the 4 through holes constitute one rectangle, and at least one edge of the rectangle is not parallel to any edge of the carrier plate.

8. The LED carrier plate according to claim 1, wherein the electrode pins comprise any of following features:
(1) the electrode pins comprise: a first pin and a second pin, wherein
the first pin is configured to electrically connect a positive electrode of an LED chip in the LED illuminants, and
the second pin is configured to electrically connect a negative electrode of the LED chip in the LED illuminants;
(2) the electrode pins comprise: the first pin and the second pin, wherein
the first pin is configured to electrically connect a first input pin of a driver IC of the LED chip in the LED illuminants, and
the second pin is configured to electrically connect a second input pin of the driver IC of the LED chip in the LED illuminants; or
(3) the electrode pins comprise: the first pin, the second pin, and a third pin, wherein
the first pin is configured to electrically connect a power supply positive electrode/VCC end of the LED illuminants;
the second pin is configured to electrically connect a power supply negative electrode/GND end of the LED illuminants; and
the third pin is configured to electrically connect a data signal input pin DIN end of the LED illuminants.

9. The LED carrier plate according to claim 1, wherein the carrier plate further comprises any of following features:
(1) data input signal wires of the LED illuminants are arranged on the carrier plate front side between 1st-row through holes and 2nd-row through holes and along a first direction on the carrier plate;
(2) the carrier plate further comprises 3rd-row through holes, wherein
ground wires of the LED illuminants are arranged on the carrier plate back side between the 1st-row through holes and the 2nd-row through holes and between the 2nd-row through holes and the 3rd-row through holes, and along the first direction on the carrier plate, wherein
a first carrier plate back side region between the 1st-row through holes and the 2nd-row through holes and a second carrier plate back side region between the 2nd-row through holes and the 3rd-row through holes are both grounded.

10. An LED display device, **characterized by** comprising the LED carrier plate according to any one of claims 1 to 9.

## Amended claims

### Amended claims under Art. 19.1 PCT

1. A LED carrier plate, **characterized by** comprising:
a carrier plate front side and a carrier plate back side, wherein a plurality of through holes pass through the carrier plate front side and the carrier plate back side, and
the plurality of through holes comprises at least 2 rows of the through holes, wherein
at least every 3 of the through holes enclose one island-shaped carrier plate region on the carrier plate front side, wherein
the island-shaped carrier plate region is provided with at least 2 electrode pins, and the electrode pins are configured to connect LED illuminants arranged on the carrier plate front side,
wherein the LED illuminants are located on the island-shaped carrier plate region, and do not shield any of the through holes; or one of the LED illuminants is arranged above one or more of the through holes, and spans and connects 2 different island-shaped carrier plate regions on two sides or surrounding of the one or more of the through holes, and still connects to 2 electrode pins of these island-shaped carrier plate regions.

2. The LED carrier plate according to claim 1, wherein the carrier plate back side does not provided with:
any IC and/or component configured to connect the LED illuminants.

3. The LED carrier plate according to claim 1, wherein
for each row of the through holes on the carrier plate, adjacent through holes are arranged with equal space in the row; and/or,
for each row of the LED illuminants on the carrier plate, adjacent LED illuminants are arranged with equal space in the row.

4. The LED carrier plate according to claim 1, wherein
the carrier plate does not provided with grilles in rows or columns.

5. The LED carrier plate according to claim 1, wherein
at least every 4 of the through holes enclose one island-shaped carrier plate region.

6. The LED carrier plate according to claim 1, wherein
the carrier plate is polygonal or circular.

7. The LED carrier plate according to claim 1, wherein
when at least every 4 of the through holes enclose one island-shaped carrier plate region,
geometric center lines of the 4 through holes constitute one rectangle, and one edge of the rectangle is parallel or perpendicular to one edge of the carrier plate; or
geometric center lines of the 4 through holes constitute one rectangle, and at least one edge of the rectangle is not parallel to any edge of the carrier plate.

8. The LED carrier plate according to claim 1, wherein the electrode pins comprise any of following features:
(1) the electrode pins comprise: a first pin and a second pin, wherein
the first pin is configured to electrically connect a positive electrode of a LED chip in the LED illuminants, and
the second pin is configured to electrically connect a negative electrode of the LED chip in the LED illuminants;
(2) the electrode pins comprise: the first pin and the second pin, wherein
the first pin is configured to electrically connect a first input pin of a driver IC of the LED chip in the LED illuminants, and
the second pin is configured to electrically connect a second input pin of the driver IC of the LED chip in the LED illuminants; or
(3) the electrode pins comprise: the first pin, the second pin, and a third pin, wherein
the first pin is configured to electrically connect a power supply positive electrode/VCC end of the LED illuminants;
the second pin is configured to electrically connect a power supply negative electrode/GND end of the LED illuminants; and
the third pin is configured to electrically connect a data signal input pin DIN end of the LED illuminants.

9. The LED carrier plate according to claim 1, wherein the carrier plate further comprises any of following features:
(1) data input signal wires of the LED illuminants are arranged on the carrier plate front side between 1st-row through holes and 2nd-row through holes and along a first direction on the carrier plate;
(2) the carrier plate further comprises 3rd-row through holes, wherein
ground wires of the LED illuminants are arranged on the carrier plate back side between the 1st-row through holes and the 2nd-row through holes and between the 2nd-row through holes and the 3rd-row through holes, and along the first direction on the carrier plate, wherein
a first carrier plate back side region between the lst-row through holes and the 2nd-row through holes and a second carrier plate back side region between the 2nd-row through holes and the 3rd-row through holes are both grounded.

10. A LED display device, **characterized by** comprising the LED carrier plate according to any one of claims 1 to 9.
